# EUROPÄISCHE PATENTSCHRIFT

(11) **EP 2 605 034 B1**
(45) Veröffentlichungstag und Bekanntmachung des Hinweises auf die Patenterteilung: **09.04.2014**
(21) Anmeldenummer: 12191028.5
(22) Anmeldetag: 02.11.2012
(51) Int. Cl.: G01S 17/10, G01S 7/487, H03K 17/94

(54) **Vorrichtung und Verfahren zur Laufzeitmessung eines optischen Impulses**
Apparatus and method for measuring propagation time of an optical pulse
Dispositif et procédé de la mesure de temps de propagation d'une impulsion optique

(30) Priorität: 14.12.2011 AT 500062011
(43) Veröffentlichungstag der Anmeldung: 19.06.2013
(73) Patentinhaber: Riegl Laser Measurement Systems GmbH, 3580 Horn (AT)
(72) Erfinder: Hofbauer, Andreas, 3910 Zwettl (AT); Pfennigbauer, Martin, 3430 Tulln (AT); Ullrich, Andreas, 3003 Gablitz (AT)
(74) Vertreter: Weiser, Andreas

(56) Entgegenhaltungen:
- EP-A1- 0 107 042
- EP-A2- 2 315 053
- US-A- 5 703 368
- US-A1- 2010 019 903

## Beschreibung

Die vorliegende Erfindung betrifft eine Vorrichtung und ein Verfahren zur Laufzeitmessung eines optischen Impulses in einem optischen Signal.

Aus der US 2010/0019903 A1 ist ein Infrarot-Bewegungsmelder mit zwei auf unterschiedliche, in der Ferne überlappende Überwachungsbereiche gerichteten Infrarotsensoren bekannt, deren Ausgangssignale auf das gleichzeitige Auftreten von Bewegungsimpulsen überwacht werden, um Fehlalarme durch Insekten oder Vögel, die nur einen der Sensoren in der Nähe passieren, auszuschließen.

Die Schrift EP 2 315 053 A2 beschreibt ein System zum Messen der Empfangszeitpunkte von Impulsen, welches in einer Ausführungsform zur Erhöhung der Messgenauigkeit der Impulsempfangszeitpunkte Impulse in mehreren parallelen Empfangskanälen mit Sätzen paralleler Referenzimpulse vergleicht.

Für die Detektion von kleinsten optischen Impulsen werden vermehrt Empfangselemente mit besonders hoher Empfindlichkeit verwendet. Beispiele solcher hochempfindlicher Detektoren sind Photomultiplier-Röhren und Hybrid-Photon-Detektoren (HPDs). Theoretisch können so Impulse, die aus nur wenigen Photonen bestehen, in verwertbare elektrische Impulse umgewandelt werden. Dabei lösen neben den erwünschten Signalphotonen jedoch auch Photonen von unvermeidlichem Hintergrundlicht (Sonne, künstliche Lichtquellen, heiße Oberflächen etc.), aber auch andere Teilchen, z.B. Röntgenstrahlung oder kosmische Hintergrundstrahlung, elektrische Impulse aus. Darüber hinaus kann es bei besonders empfindlichen optoelektronischen Empfangselementen sogar ohne Einfluss von außen aufgrund quantenmechanischer Effekte zur spontanen Erzeugung von elektrischen Impulsen im Empfangselement selbst kommen.

Die so entstehenden Störimpulse können zwar durch geeignete Maßnahmen wie räumliche, spektrale und zeitliche Filterung etwas verringert werden, jedoch bleiben dabei gerade jene Störpulse bestehen, deren Amplitude hoch und nicht durch die Intensität des vom Empfangselement aufgenommenen Lichts erklärbar ist. Beispielsweise im Kontext der Laser-Entfernungsmessung würden solche großen elektrischen Störimpulse fälschlicherweise einem großen optischen Echoimpuls zugeordnet werden und ein real nicht vorhandenes Messziel anzeigen.

Die Erfindung setzt sich zum Ziel, dieses Problem zu überwinden, um die hohe Empfindlichkeit moderner optoelektrischer Empfangselemente für optische Impulslaufzeit-Messverfahren, wie die Laser-Entfernungsmessung, besser nutzbar zu machen.

Dieses Ziel wird in einem ersten Aspekt der Erfindung mit einer Vorrichtung mit den Merkmalen des Anspruchs 1 erreicht.

In einem zweiten Aspekt der Erfindung wird dieses Ziel mit einem Verfahren mit den Merkmalen des Anspruchs 8 erreicht.

Die Erfindung beruht auf dem Ansatz, das optische Signal auf mindestens zwei Empfangselemente aufzuteilen und die entstehenden elektrischen Signale zu vergleichen, um in einem Empfangselement zufällig auftretende, "falsche" Impulse als Störimpulse zu erkennen und in der Weiterverarbeitung zu unterdrücken. Als "echte" bzw. korrekte Impulse werden nur solche Impulse identifiziert, die - unter Berücksichtigung allfälliger Signallaufzeitunterschiede der beiden Empfangskanäle und innerhalb vorgegebener Toleranzen - gleichzeitig (koinzident) in beiden Empfangskanälen auftreten. Wie nachstehend ausgeführt, kann dazu entweder in jedem Kanal separat eine Schwellwertdetektion vorgenommen und anschließend der Koinzidenzvergleich durchgeführt werden ("post-detection correlation"), oder die Ausgänge der Empfangselemente werden direkt für den Koinzidenz-vergleich miteinander verknüpft und erst dann einer gemeinsamen Schwellwertdetektion unterzogen ("pre-detection correlation"). Die Verknüpfung kann dabei beliebige Komplexität haben, insbesondere wenn die Empfangselemente deutlich unterschiedliches Rauschverhalten haben oder überhaupt gänzlich verschiedenen Typs sind.

Die Erfindung erlaubt damit den Betrieb von hochempfindlichen Empfangselementen mit einer höheren "Störimpulsrate" bzw. "Fehltriggerrate", als dies mit einer Einzelauswertung nach dem Stand der Technik möglich wäre. Bei modernen hochempfindlichen Empfangselementen ist die Störimpulsrate häufig vom Arbeitspunkt, z.B. einer Vorspannung des Empfangselements, abhängig, welcher wiederum die Empfindlichkeit definiert: Mit Hilfe der Erfindung kann z.B. eine höhere Vorspannung gewählt und damit eine größere Empfindlichkeit erreicht werden, ohne dass die damit einhergehende höhere Fehltriggerrate der einzelnen Empfangselemente die Detektionssicherheit der Impulsdetektion beeinträchtigt. Im Ergebnis kann mit Hilfe der Erfindung die hohe Empfindlichkeit moderner optoelektrischer Empfangselemente besser nutzbar gemacht werden.

In einer einfachen Ausführungsform der Erfindung kann die Auswerteschaltung lediglich die Tatsache des Auftretens von (signallaufzeitbereinigt) koinzidenten Impulsen als Detektionsergebnis auf einem Ausgang ausgeben. Bevorzugt sind die Auswerteschaltung der erfindungsgemäßen Vorrichtung und das Verfahren der Erfindung jedoch auch dafür ausgebildet, beim Detektieren den Auftrittszeitpunkt des optischen Impulses aus dem Auftrittszeitpunkt zumindest eines der genannten elektrischen Impulse in seinem Signal zu bestimmen.

Bevorzugt ist zumindest ein Empfangselement hochempfindlich, z.B. enthält es eine Lawinenphotodiode oder einen Photoelektronenvervielfacher (Photo Multiplier Tube), bevorzugt einen Hybrid-Photon-Detektor. In einer ersten Variante der Erfindung können alle Empfangselemente von gleichem hochempfindlichen Typ sein, z.B. Hybrid-Photon-Detektoren. In einer zweiten Variante können nur eines oder manche der Empfangselemente hochempfindlich sein, z.B. in Form eines Photoelektronenvervielfachers, einer Lawinenphotodiode oder eines Hybrid-Photon-Detektors, und eines oder manche andere Empfangselemente im Vergleich dazu geringempfindlich, z.B. "herkömmliche" optoelektronische Empfangselemente wie Photodioden, CCD-Sensoren od.dgl. Diese Ausführungsform beruht auf der Annahme, dass ein zufälliger Störimpuls aus dem hochempfindlichen Empfangselement stets so groß ist, dass selbst ein herkömmliches geringempfindliches Empfangselement an dieser Stelle ein entsprechendes Signal hätte liefern müssen. Durch eine solche Mischung von hochempfindlichen und geringempfindlichen Empfangselementen können - wenn auch um den Preis insgesamt verringerterten Empfindlichkeit - Kosten gespart werden.

Die Aufteilung des optischen Signals auf die parallelen Empfangskanäle bzw. deren Empfangselemente kann im einfachsten Fall dadurch erfolgen, dass die Empfangselemente z.B. so nahe nebeneinander (oder hintereinander versetzt) angeordnet werden, dass das optische Signal ("Lichtstrahl") alle Empfangselemente mit jeweils einem Anteil trifft. Dies kann auch durch eine entsprechende Empfangsoptik unterstützt werden. Wenn dies nicht möglich oder zweckmäßig ist, wird bevorzugt ein optischer Strahlteiler eingesetzt, welcher für die Aufteilung des optischen Signals in die genannten Anteile sorgt.

Das optische Signal kann mit einem solchen Strahlteiler symmetrisch auf alle Empfangskanäle aufgeteilt werden, d.h. die genannten Anteile stehen im Verhältnis von 50:50, 33:33:33, 25:25:25:25, usw. usf. Gemäß einer weiteren Ausführungsform der Erfindung können die Anteile jedoch auch ungleich groß gewählt werden, z.B. bei zwei Empfangskanälen 40:60, 30:70, 20:80, 10:90 usw., was einen zusätzlichen Freiheitsgrad bei der Auslegung der Vorrichtung und des Verfahrens der Erfindung bietet. Die Aufteilung kann dadurch optimal an die Empfindlichkeit der Empfangselemente angepasst werden.

Besonders günstig ist es, wenn der größere Anteil dem Empfangskanal mit dem hochempfindlichen Empfangselement zugeführt wird, um dessen Empfindlichkeit maximal auszunützen; der andere Empfangskanal mit dem geringempfindlichen Empfangselement wird dann gleichsam als Hilfs-Kanal für den Koinzidenz-Vergleich zur genannten Ausblendung von Störsignalen aus dem empfindlichen Empfangskanal verwendet.

Die genannte Auswerteschaltung, welche (unter Berücksichtigung allfälliger Signallaufzeitunterschiede) die Gleichzeitigkeit bzw. Koinzidenz von elektrischen Impulsen in den ihr zugeführten Signalen feststellt, kann auf verschiedene vorteilhafte Arten realisiert werden. In einer ersten Ausführungsform der Erfindung entsprechend einem "pre-detection correlation"-Verfahren weist die Auswerteschaltung einen an die Ausgänge aller Empfangselemente angeschlossenen Multiplizierer auf, dessen Ausgang einem Schwellwertdetektor zugeführt ist. In einer alternativen Ausführungsform entsprechend einem "postdetection correlation"-Verfahren umfasst die Auswerteschaltung für jedes Empfangselement einen an dessen Ausgang angeschlossenen Schwellwertdetektor, wobei die Ausgänge aller Schwellwertdetektoren einem UND-Glied zugeführt sind. Bei letzterer Variante kann jeder Empfangskanal individuell mit Hilfe eines eigenen Schwellwertdetektors analysiert werden, der wie später erläutert auch zusätzliche Analysen wie eine Auswertung der Impulsbreite vornehmen kann. Hingegen hat die erstgenannte "pre-detection correlation"-Ausführungsform den Vorteil, dass sie hinsichtlich der Schwellwertdetektion nur den halben Signalverarbeitungsaufwand bedeutet.

Um die Detektionssicherheit weiter zu erhöhen, kann zusätzlich zu der (signallaufzeitbereinigten) Koinzidenz von Impulsen in den Empfangskanälen auch die Amplitude und/oder Impulsform koinzidenter Impulse überprüft werden. In einer ersten bevorzugten Variante der Erfindung ist demgemäß die Auswerteschaltung dafür ausgebildet, einen optischen Impuls nur dann zu detektieren, wenn die in einem vorgegebenen Zeitabstand auftretenden elektrischen Impulse - gegebenenfalls kompensiert um Verstärkungsunterschiede der Empfangselemente und um das Verhältnis der Strahlteilung - auch annähernd gleiche Amplitude haben. Dies beruht auf der Erkenntnis, dass ein "echter" elektrischer Impuls, der durch einen optischen Impuls ausgelöst wurde, in allen Empfangskanälen - verstärkungskorrigiert - eine ähnlich große Amplitude haben muss.

Beispielsweise kann die Auswerteschaltung dazu einen an die Ausgänge aller Empfangselemente angeschlossenen Komparator aufweisen, welcher die Amplituden der Signale vergleicht und, wenn sich diese innerhalb eines Toleranzfensters gleichen, ein Ausgangssignal abgibt, das z.B. diese (gleiche) Amplitude hat. Bevorzugt wird dem Komparator ein weiterer Schwellwertdetektor nachgeschaltet, welcher diese gleiche Amplitude auswertet und erst bei einer Schwellwertüberschreitung den optischen Impuls detektiert. Alternativ oder zusätzlich können dem Komparator auch an seinen Eingängen Schwellwertdetektoren vorgeschaltet werden, die dessen Amplitudenvergleich nur in Anspruch nehmen, wenn die Signale eine Mindestamplitude überschreiten.

Alternativ (oder zusätzlich) kann die Auswerteschaltung auch dafür ausgebildet sein, einen optischen Impuls nur dann zu detektieren, wenn die in einem vorgegebenen Zeitabstand auftretenden elektrischen Impulse auch annähernd gleiche oder einander in einer Datenbank zugeordnete Impulsformen haben. Dies beruht auf der weiteren Erkenntnis, dass ein "echter" elektrischer Impuls, der durch ein- und denselben optischen Impuls ausgelöst wurde, in allen Empfangskanälen entweder gleiche Impulsformen (wenn die Empfangselemente gleichartig sind) oder einander zuordenbare Impulsformen (wenn die Empfangselemente verschiedenartig sind) hervorruft: So können durch Testreihen die von verschiedenen Empfangselementen erzeugten, auf ein- und denselben optischen Impuls zurückzuführenden Impulsformen voraufgezeichnet und in einer Datenbank einander zugeordnet werden; im späteren "online"-Detektionsbetrieb auftretende Impulsformen können dann in der Datenbank auf gegenseitige Zuordnung überprüft und, wenn sie einander zugeordnet sind, als zusätzliches Kriterium für die Zusammengehörigkeit koinzidenter Impulse verwendet werden.

Die Vorrichtung der Erfindung kann in allen ihren Ausführungsformen in Analogtechnik aufgebaut werden, z.B. mit Hilfe analoger Multiplizierer und Schwellwertdetektoren, Komparatoren, Subtrahierer usw. Alternativ können die Ausgänge der Empfangselemente über Analog/Digital-Wandler geführt und die übrige Vorrichtung in Digitaltechnik aufgebaut sein, wodurch die Integrierbarkeit, Flexibilität und geringen Massenproduktionskosten digitaler Signalverarbeitungselemente ausgenützt werden können.

In einem weiteren Aspekt umfasst das Detektionsverfahren der Erfindung die zusätzlichen Schritte:
Entfernen aller einen Schwellwert überschreitenden elektrischen Impulse mit Ausnahme des zum Zeitpunkt des detektierten optischen Impulses auftretenden elektrischen Impulses aus zumindest einem der Signale, um zumindest ein auf diese Weise bereinigtes Signal zu erzeugen; und
Verwenden des zumindest einen bereinigten Signals zur genaueren Bestimmung des Auftrittszeitpunkts;
oder die zusätzlichen Schritte:
   Entnehmen eines Abschnitts aus zumindest einem der Signale, welcher durch ein Zeitfenster um den Auftrittszeitpunkt des genannten elektrischen Impulses darin definiert ist; und
   Verwenden des zumindest einen entnommenen Abschnitts zur genaueren Bestimmung des Auftrittszeitpunkts.

Besonders günstig ist es, wenn derart bereinigte Signale bzw. Abschnitte aus zumindest zwei Signalen erzeugt und zu einem Signalsatz zusammengestellt oder zu einem Summensignal summiert werden, welcher bzw. welches zur genaueren Bestimmung des Auftrittszeitpunkts verwendet wird.

Diese Ausführungsformen kombinieren die erörterten Vorteile der Koinzidenz-Detektion mit den Vorteilen eines "pre-detection averaging", d.h. einer Mittelung von mehreren Empfangssignalen vor einer Schwellwertdetektion, welche das Signal/Rausch-Verhältnis mit der Wurzel aus der Anzahl der gemittelten Empfangssignale verbessert.

Die genannte genaue Bestimmung kann eine neuerliche Schwellwertdetektion sein, nun mit einem bereinigten Summensignal mit verbessertem Signal/Rausch-Verhältnis, oder ein "Ein-passen" eines Referenzimpulses bekannter Zeitlage in den detektierten Impuls, woraus der Auftrittszeitpunkt noch exakter ermittelt werden kann.

Die Erfindung wird nachstehend anhand von in den beigeschlossenen Zeichnungen dargestellten Ausführungsbeispielen näher erläutert. In den Zeichnungen zeigen:
Fig. 1 ein Blockschaltbild der Vorrichtung der Erfindung, welche nach dem erfindungsgemäßen Verfahren arbeitet;
die Fig. 2 und 3 Zeitdiagramme von optischen und elektrischen Signalen, die in der Vorrichtung von Fig. 1 und dem erfindungsgemäßen Verfahren auftreten;
die Fig. 4 bis 7 verschiedene Ausführungsformen der Auswerteschaltung der Vorrichtung von Fig. 1;
Fig. 8a die Ein- und Ausgangssignale eines beispielhaften Schwellwertdetektors im Rahmen der Erfindung und Fig. 8b die teilweise Koinzidenzüberlappung der Abtastwerte realer Impulsformen; und
die Fig. 9 und 10 Zeitdiagramme von elektrischen Signalen, die in weiteren Ausführungsformen des erfindungsgemäßen Verfahrens auftreten.

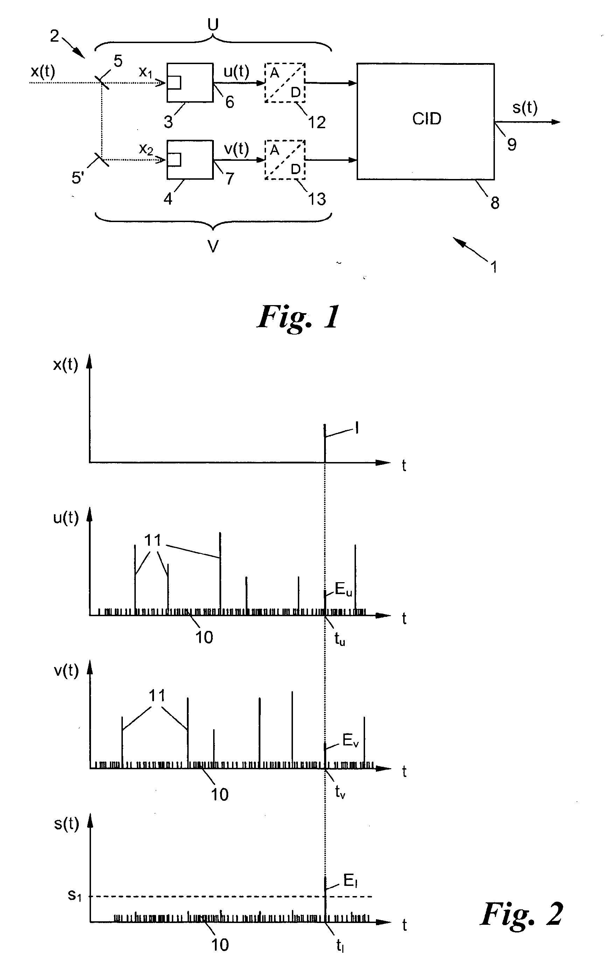

In Fig. 1 ist eine Vorrichtung 1 zur Detektion von optischen Impulsen I (Fig. 2) gezeigt, welche im Rahmen eines optischen Signals x(t), z.B. in Form eines Laserstrahls, auf die Vorrichtung 1 auftreffen. Der Begriff "Detektieren" eines Impulses I umfasst hier sowohl das bloße Erkennen der Tatsache, dass überhaupt ein Impuls I auftritt, als auch das Erkennen dieser Tatsache und Bestimmen des Auftrittszeitpunkts tᵢ des Impulses I im optischen Signal x(t) in einem Zeitmaßstab t.

Das optische Signal x(t) wird einem optischen Strahlteiler 2 zugeführt, welcher dieses auf zumindest zwei parallele Empfangskanäle U, V mit je einem optoelektronischen Empfangselement 3, 4 aufteilt. Jeder Empfangskanal U, V bzw. jedes optoelektronische Empfangselement 3, 4 erhält damit einen Anteil x₁, x₂ des optischen Signals x(t). Die Anteile x₁, x₂ können sich auf 100% des optischen Signals x(t) summieren, soferne keine Streu- und Abschwächungsverluste vorliegen.

Die Strahlteilung x₁:x₂ kann bevorzugt symmetrisch erfolgen, d.h. bei im vorliegenden Beispiel zwei Empfangskanälen x₁:x₂ = 50:50. Optional können auch unterschiedliche Teilungsverhältnisse verwendet werden, z.B. 40:60, 30:70; 20:80, 10:90 usw., insbesondere im Zusammenhang mit unterschiedlich empfindlichen Empfangskanälen U, V, wie später noch ausführlicher erläutert wird.

Der Strahlteiler 2 kann beispielsweise einen oder mehrere halbdurchlässige Spiegel- oder Strahlteilerplatten 5 und einen oder mehrere Umlenkspiegel 5' umfassen, z.B. auch kaskadiert, wenn mehr als zwei Empfangselemente 3, 4 gespeist werden sollen. Auch jede andere in der Technik bekannte Art von optischem Strahlteiler ist geeignet.

In einer vereinfachten Ausführungsform kann der Strahlteiler 2 auch entfallen, wenn die Empfangselemente 3, 4 so nahe nebeneinander (oder auch hintereinander versetzt) angeordnet werden, dass das optische Signal x(t) auf beide Empfangselemente 3, 4 mit jeweils einem Anteil auftreffen kann. Beispielsweise unterliegt selbst ein stark gebündelter Laserstrahl nach einiger Entfernung und insbesondere nach einer Reflexion stets einer gewissen Strahlaufweitung, sodass der üblicher Strahldurchmesser eines reflektierten Laserstrahls, der das optische Signal x(t) bildet, ausreichen kann, um zwei oder mehr Empfangselemente 3, 4 abzudecken. Zusätzlich kann durch eine der Vorrichtung 1 vorgeschaltete Empfangsoptik (nicht dargestellt) eine entsprechende Konditionierung des optischen Signals x(t) erfolgen, um beide Empfangselemente 3, 4 zu erreichen. Wenn der Strahlteiler 2 entfällt, kann die unterschiedliche Anteils-Aufteilung x₁:x₂ beispielsweise durch zusätzliche Abschwächelemente vor einem der Empfangselemente 3, 4 realisiert werden, falls gewünscht.

Die Empfangselemente 3, 4 wandeln jeweils das auf sie auftreffende optische Signal x(t) in ein elektrisches Signal u(t) bzw. v(t) um, in dem sich jeder optische Impuls I aus dem optischen Signal x(t) als ein elektrischer Impuls Eᵤ bzw. Eᵥ niederschlägt (Fig. 2). Die Signale u(t) und v(t) werden auf Ausgängen 6, 7 ausgegeben.

Für die Empfangselemente 3, 4 können alle Arten von in der Technik bekannten opto- bzw. photoelektrischen Elementen verwendet werden, wie Photodetektoren, Photodioden, Phototransistoren, Photozellen, Lawinenphotodioden bzw. CCD- oder CMOS-Lichtsensoren usw. Die hier vorgestellte Vorrichtung 1 und ihr Verfahren eignen sich besonders für hochempfindliche photoelektrische Elemente wie Lawinenphotodioden bzw. APDs (Avalanche Photo Diodes), SPADs (Single Photon Avalanche Diodes), GM-APDs (Geiger-Mode APDs), Si-PMs (Silicon Photomultipliers), MPPCs (Multi-Pixel Photon Counters), NFADs (Negative Feedback Avalanche Diodes), DAPDs (Discrete Amplification Photon Detectors), HPDs (Hybrid Photon Detectors), PMTs (Photo Multiplier Tubes) od. dgl., welche sogar einzelne Photonen nachweisen und als elektrische Impulse Eᵤ, Eᵥ in ihren Ausgangssignalen u(t), v(t) ausgeben können.

Auch ist es möglich, für die Empfangselemente 3, 4 unterschiedlich empfindliche optoelektronische Bauelemente zu verwenden. So kann beispielsweise - aus Kostengründen - nur für eines oder manche der Empfangselemente 3, 4 ein hochempfindliches optoelektronisches Bauteil wie ein Hybrid-Photon-Detektor verwendet werden, und für das andere oder manche andere ein "herkömmliches" geringempfindliches optoelektronisches Bauteil wie eine Photodiode.

Unterschiedlich empfindlichen Empfangselementen 3, 4 können auch unterschiedliche Anteile x₁, x₂ des optischen Signals x(t) zugeführt werden, sei es zur Kompensation der unterschiedlichen Empfindlichkeiten oder um diese sogar noch zu verstärken: So kann einem hochempfindlichen Empfangselement 3, 4 sogar noch ein größerer Anteil x₁, x₂ zugeführt werden, um dessen hohe Empfindlichkeit maximal auszunutzen, wobei dann das andere (gering empfindliche) Empfangselement 3, 4 gleichsam einen "Hilfs-Kanal" für die im weiteren geschilderte Störsignalunterdrückung bildet.

An die Ausgänge 6, 7 der Empfangselemente 3, 4 ist eine Auswerteschaltung 8 angeschlossen, die gleichzeitig (koinzident) in ihren Eingangssignalen u(t), v(t) auftretende elektrische Impulse Eᵤ, Eᵥ detektiert ("coincidence detection", CID) und im Detektionsfall auf einem Ausgang 9 in einem Ausgangssignal s(t) einen Impuls E_{I} ausgibt (Fig. 2). Der Ausgangsimpuls E_{I} der Auswerteschaltung 8 repräsentiert den detektierten optischen Impuls I und optional auch seinen Auftrittszeitpunkt t_{I}.

Der Auftrittszeitpunkt t_{I} kann in weiterer Folge entsprechend ausgewertet werden. Ein Anwendungsbeispiel ist die Impulslaufzeitmessung in einem Laser-Entfernungsmesser oder Laser-Scanner, von welchem optische Impulse I ausgesandt, an zu vermessenden Objekten in der Umgebungsobjekten reflektiert und in der Vorrichtung 1 empfangen werden, wobei aus der Differenz zwischen bekanntem Sendezeitpunkt und gemessenem Empfangszeitpunkt (Auftrittszeitpunkt t_{I}) die optische Impulslaufzeit und damit die Entfernung zu einem Umgebungsobjekt bestimmt werden kann.

Es versteht sich, dass die Auswerteschaltung 8 den Auftrittszeitpunkt t_{I} auch selbst bestimmen und z.B. auf einem (nicht dargestellten) Digitalausgang in numerischer Form ausgeben kann. Im einfachsten Fall wird der Auftrittszeitpunkt t_{I} nicht weiter ausgewertet, und die Tatsache des Auftretens eines Impulses E_{I} im Signal s(t) am Ausgang 9 zeigt einfach nur die Tatsache des Einlangens eines optischen Impulses I in der Vorrichtung 1 als Detektionsergebnis an.

Fig. 2 zeigt die Signale x(t), u(t), v(t) und s(t) über der Zeit t im Detail. Aufgrund der hohen Empfindlichkeit der Empfangselemente 3, 4 treten in den Ausgangssignalen u(t) und v(t) wie eingangs erwähnt neben den "echten" Impulsen Eᵤ und Eᵥ und unabhängig vom Empfänger-Grundrauschen ("noise floor") 10 auch hin und wieder Störimpulse 11 hoher Amplitude zu zufälligen Zeitpunkten auf. Solche stochastische Störimpulse 11 haben wesentlich höhere Amplitude als das Grundrauschen 10 und können sogar größere Amplitude haben als die echten Impulse Eᵤ und Eᵥ. Aufgrund ihrer stochastischen Verteilung über die Zeit t ist es jedoch sehr unwahrscheinlich, dass solche Störimpulse 11 gleichzeitig in zwei oder mehreren Ausgangssignalen u(t), v(t) auftreten.

Die Auswerteschaltung 8 nützt diesen Umstand und berücksichtigt bzw. detektiert nur jene Impulse Eᵤ, Eᵥ, die zum selben Zeitpunkt tᵤ = tᵥ = t_{I} in den Signalen u(t) und v(t) auftreten, und unterdrückt damit alle Störimpulse 11. Das unterste Diagramm von Fig. 2 zeigt das Ausgangssignal s(t) der Auswerteschaltung 8 als Ergebnis dieser Koinzidenz-Detektion. Das Grundrauschen 10 bleibt bestehen, doch die stochastischen Störimpulse 11 großer Amplitude sind unterdrückt; der richtige Impuls E_{I} zum Auftrittszeitpunkt t_{I} ist nun gut erkennbar und kann beispielsweise durch Schwellwertdetektion gegenüber einem Schwellwert s₁, um ihn vom Grundrauschen 10 zu unterscheiden, detektiert werden.

Es versteht sich, dass die Vorrichtung 1 auch mehr als zwei Empfangselemente 3, 4 aufweisen kann und dementsprechend mehr als zwei Signale u(t), v(t), ... von der Auswerteschaltung 8 auf Koinzidenz von Impulsen Eᵤ, Eᵥ, ... überprüft werden können. Im Falle einer solchen Mehrzahl von Signalen kann ein Impuls I als detektiert gelten, wenn alle der drei oder mehr Signale u(t), v(t), ... einen elektrischen Impuls Eᵤ, Eᵥ, ... zum gleichen Zeitpunkt t_{I} zeigen, oder wenn die *Mehrheit* aller Signale dieses zeigt, oder wenn zumindest zwei Signale dieses zeigen. Die Auswerteschaltung 8 kann dazu entsprechende logische Verknüpfungen durchführen.

Die Vorrichtung 1 kann vollständig in Analogtechnik oder auch so weit wie möglich in Digitaltechnik ausgeführt werden. Zu letzterem Zweck können die Ausgänge 6, 7 der Empfangselemente 3, 4 über Analog/Digital-Wandler 12, 13 den Eingängen der Auswerteschaltung 8 zugeführt werden, die dann z.B. mit Hilfe eines oder mehrerer Signalprozessoren aufgebaut wird.

Es versteht sich, dass die anhand der Fig. 1 und 2 beschriebene Koinzidenz bzw. der Gleichzeitigkeitsdetektion der Impulse Eᵤ und Eᵥ allfällige Unterschiede in den Signallaufzeiten, welche in den Empfangskanälen U, V, d.h. jeweils vom Eingang des Strahlteilers 2 bis zu den Ausgängen 6, 7 der Empfangselemente 3, 4 (bzw. allfälliger Analog/Digital-Wandler 12, 13) auftreten, berücksichtigen sollte. Solche Signallaufzeitunterschiede können durch unterschiedliche Weglängen, die der optische Impuls I im Strahlteiler 2 zurücklegt, und/oder durch verschiedenartige Empfangselemente 3, 4 und Analog/DigitalWandler 12, 13 bedingt sein, welche z.B. unterschiedliches Ansprechverhalten zeigen oder verschiedene Verzögerungszeiten zwischen ihren Ein- und Ausgängen haben.

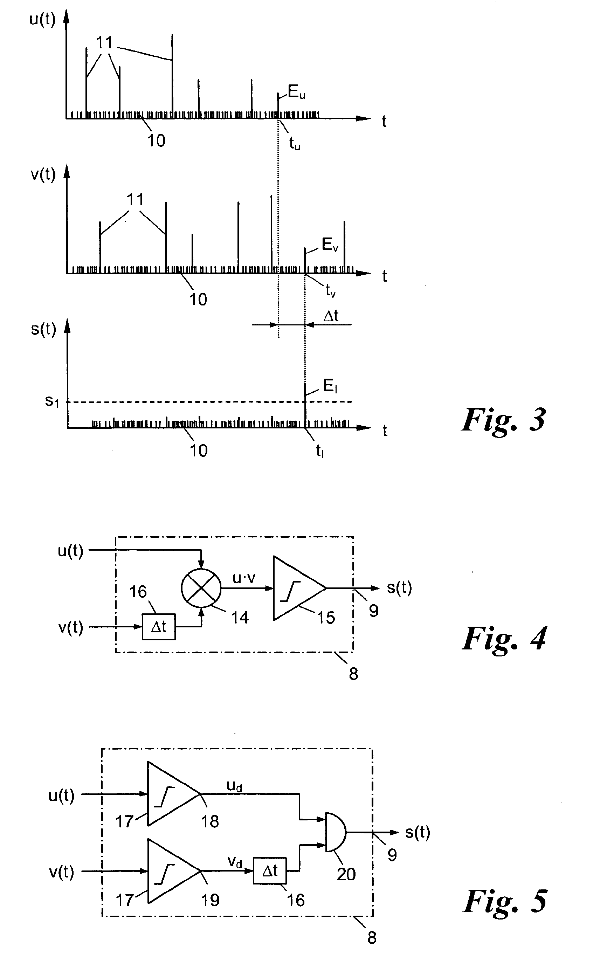

Fig. 3 zeigt dies im Detail. Wenn der Signallaufzeitunterschied zwischen den Empfangskanälen U (5 - 3 - 6 - 12) einerseits und V (5 - 5' - 4 - 7 - 13) andererseits Δt beträgt, sind elektrische Empfangsimpulse Eᵤ und Eᵥ im genannten Sinne "koinzident", wenn sie in einem Zeitabstand Δt aufeinanderfolgen, der gleich dem Signallaufzeitunterschied Δt ist. Die Auswerteschaltung 8 detektiert demgemäß Impulse Eᵤ und Eᵥ als koinzident, wenn sie in einem vorgegebenen Zeitabstand Δt aufeinanderfolgen, welcher dem Signallaufzeitunterschied Δt zwischen den Empfangskanälen entspricht, wie er beispielsweise durch Referenzmessungen einmal ermittelt und dann der Auswerteschaltung 8 vorgegeben werden kann. Bei der Bestimmung des Auftrittszeitpunkts t_{I} im Zeitmaßstab t ist der Signallaufzeitunterschied Δt entsprechend zu berücksichtigen, je nachdem, ob der Auftrittszeitpunkt tᵤ des Impulses Eᵤ und/oder der Auftrittszeitpunkt tᵥ des Impulses Eᵥ im jeweiligen Zeitmaßstab t dazu herangezogen wird.

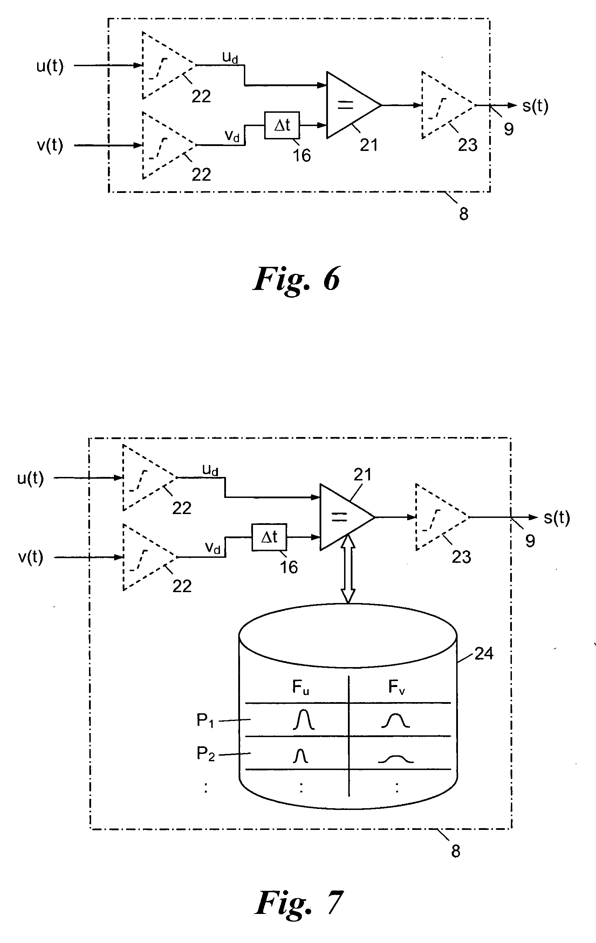

Die Fig. 4 bis 7 zeigen mögliche Implementierungsformen der Auswerteschaltung 8, welche sowohl in Analogtechnik (Fig. 5 und 7 nur teilweise) als auch in Digitaltechnik (mit entsprechenden Analog/Digital-Wandlern 12, 13) ausgebildet werden können. Es versteht sich, dass im Falle von Digitaltechnik die dargestellten Hardwarekomponenten auch durch entsprechende Softwarekomponenten eines entsprechend programmierten Signalprozessors, Mikroprozessors oder Computers realisiert werden können.

Fig. 4 zeigt eine erste Ausführung der Auswerteschaltung 8, die ein "pre-detection correlation"-Verfahren implementiert. Die Signale u(t), v(t) der Empfangselemente 3, 4 sind hier einem Multiplizierer 14 zugeführt, der das Produkt s(t) = u(t) . v(t) (jeweils "offset-bereinigt", d.h. ohne Gleichanteile) berechnet. Der Ausgang des Multiplizierers 14 ist bevorzugt (wenn auch nicht zwingend) über einen Schwellwertdetektor 15 geführt, der den in Fig. 2 gezeigten Vergleich gegenüber dem Schwellwert s₁ durchführt. Signallaufzeitunterschiede Δt zwischen den Empfangskanälen U, V können z.B. durch ein entsprechendes Zeitverzögerungsglied 16 in einem Empfangskanal berücksichtigt werden, welches diesen um den Zeitabstand Δt verzögert.

Fig. 5 zeigt eine alternative Ausführungsform der Auswerteschaltung 8, welche ein "post-detection correlation"-Verfahren implementiert. Hier werden die Signale u(t), v(t) jeweils gesonderten Schwellwertdetektoren 17 zugeführt, deren Ausgänge 18, 19 an die Eingänge eines UND-Glieds 20 angeschlossen sind, das eine logische UND-Verknüpfung der Detektionssignale u_{d}(t), v_{d}(t) der Ausgänge 18, 19 durchführt. Das Zeitverzögerungsglied 16 kann vor oder nach einem Schwellwertdetektor 17 eingefügt werden.

Auch Kombinationen der Ausführungsformen von Fig. 4 und 5 sind möglich, beispielsweise indem die Signale u(t), v(t) über gesonderte Schwellwertdetektoren 17 dem Multiplizierer 14 der Auswerteschaltung 8 von Fig. 4 zugeführt werden.

Fig. 6 zeigt eine weitere Ausführungsform der Auswerteschaltung 8 auf Grundlage eines Komparators 21, dem die Signale u(t), v(t) der Empfangselemente 3, 4 über optionale Schwellwertdetektoren 22 aufgegeben werden und dem ein weiterer optionaler Schwellwertdetektor 23 nachgeschaltet sein kann. Der Komparator 21 vergleicht die Amplituden der Signale u(t), v(t); wenn diese - unter Berücksichtigung des Zeitabstands Δt im Zeitglied 16 - koinzident und annähernd gleich sind, d.h. innerhalb eines Toleranzbereichs bzw. -fensters liegen, detektiert er dies als Auftreten eines Impulses I und gibt das Detektionsergebnis als Impuls E_{I} im Signal s(t) auf dem Ausgang 9 aus, gegebenenfalls erst nach Schwellwertvergleich im optionalen Schwellwertdetektor 23. Die Ausführungsform von Fig. 6 beruht auf der Einsicht, dass echte Impulse Eᵤ und Eᵥ stets annähernd gleiche Amplitude haben, z.B. wenn der Strahlteiler ein 50:50 Teiler ist und die Empfangselemente 3, 4 gleichartig sind, hingegen Störimpulse 11 zufällige und damit meist unterschiedliche Amplituden und gegenüber dem Grundrauschen 10 stets verhältnismäßig große Amplituden haben. Die optionalen Schwellwertdetektoren 22 können dabei sicherstellen, dass nur Impulse Eᵤ und Eᵥ mit einer Mindestamplitude vom Komparator 21 auf Amplitudengleichheit überprüft werden, und der optionale Schwellwertdetektor 23, dass nur Vergleichsergebnisse einer Mindestamplitude als Impuls I gewertet werden. Allfällige Verstärkungsunterschiede in den Empfangskanälen, z.B. unterschiedliche Ausgangsamplituden der Empfangselemente 3, 4 trotz gleicher optischer Eingangsamplituden, und asymmetrische Strahlteilerverhältnisse von x₁:x₂ ≠ 50:50 sind beim Amplitudenvergleich im Komparator 21 selbstverständlich zu berücksichtigen und zu kompensieren.

Fig. 7 zeigt noch eine weitere Ausführungsform, in welcher die Auswerteschaltung 8 und insbesondere der Komparator 21 zusätzlich zur - gegebenenfalls laufzeitbereinigten (siehe Verzögerungsglied 16) - Koinzidenzdetektion und alternativ oder zusätzlich zum - gegebenenfalls verstärkungskompensierten - Amplitudenvergleich gemäß Fig. 6 auch einen Impulsformvergleich zwischen koinzidenten Impulsen Eᵤ und Eᵥ durchführt. Dazu werden in einer Datenbank 24 Tupel P₁, P₂,... von einander jeweils zugeordneten Impulsformen Fᵤ, Fᵥ,... hinterlegt. Die Impulsformen Fᵤ und Fᵥ geben die Impulsformen elektrischer Referenzimpulse Eᵤ und Eᵥ wieder, welche als Reaktion auf verschiedenste Arten (Amplituden, Pulsbreiten) von am Eingang der Vorrichtung 1 eingespeisten optischen Impulsen I an den Ausgängen 6, 7 der verschiedenen Empfangselemente 3, 4 erhalten wurden und für denselben Impuls I einander zugeordnet werden können. Für als koinzident erkannte Empfangsimpulse Eᵤ und Eᵥ vergleicht die Auswerteschaltung 8 deren Impulsform mit den in der Datenbank 24 hinterlegten Referenz-Impulsformen Fᵤ und Fᵥ und, wenn sie den in einem Tupel P₁, P₂,... einander zugeordneten Impulsformen entsprechen, werden die Impulse Eᵤ und Eᵥ als ein- und denselben optischen Impuls I repräsentierend verifiziert; dies wird als Detektionsergebnis, gegebenenfalls zusammen mit dem Auftrittszeitpunkt t_{I}, am Ausgang 9 ausgegeben. Auch hier können zusätzlich dieselben Schwellwertdetektoren 22, 23 wie bei der Ausführungsform von Fig. 6 mit derselben Funktion eingesetzt werden.

Anstelle eines vollständigen Impuls*form*-Vergleichs könnten alternativ auch nur einzelne aussagekräftige *Parameter* der Impulsformen verglichen werden, z.B. (Halbamplituden-)Impulsbreite B, (Anstiegs-)Flankensteilheit S, usw. In einem Tupel P₁, P₂,... der Datenbank 24 könnten daher jeweils auch nur einander zugeordnete Impulsform-Parameter (Bᵤ, Bᵥ) bzw. (Sᵤ, Sᵥ) hinterlegt und in der genannten Art und Weise verwendet werden.

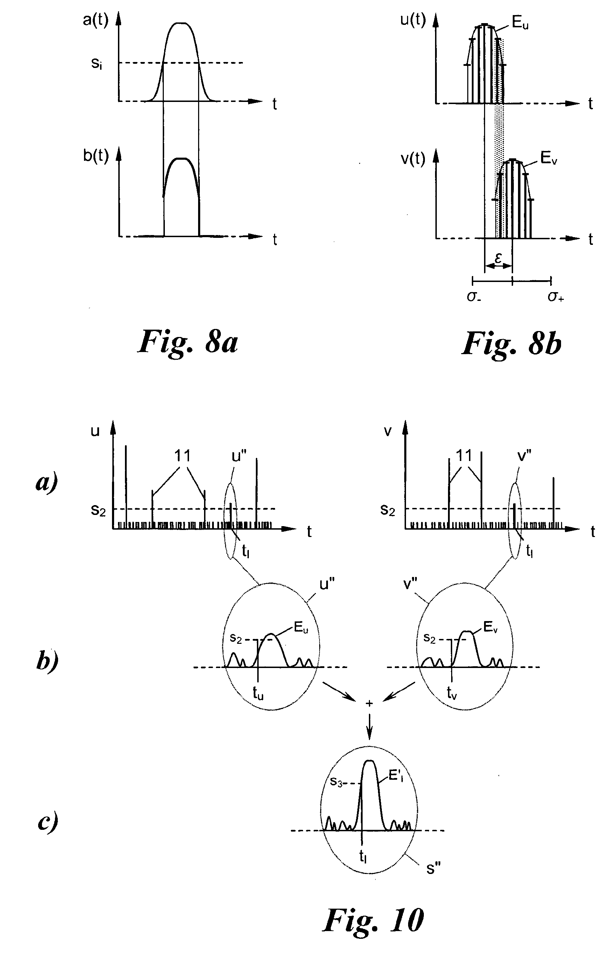

Wie in Fig. 8a gezeigt, wird unter dem Begriff "Schwellwertdetektor" in der vorliegenden Beschreibung allgemein ein Komparator, Schmitt-Trigger od.dgl. verstanden, der ein Signal a(t) an seinem Eingang mit einem vorgebbaren Schwellwert sᵢ vergleicht, das Überschreiten des Schwellwerts sᵢ detektiert und nur im Falle des Überschreitens ein von Null verschiedenes Ausgangssignal b(t) ausgibt, z.B. einen vorgegebenen Amplitudenwert oder das Eingangssignal a(t) selbst.

Die hier betrachteten Schwellwertdetektoren können bei dem Schwellwertvergleich auch zusätzliche Eigenschaften des Eingangssignals a(t) berücksichtigen, beispielsweise die Impulsbreite und/oder Impulsform von Impulsen im Eingangssignal. Beispielsweise können die Schwellwertdetektoren nur auf solche Eingangsimpulse ansprechen, die zusätzlich zu einer den Schwellwert sᵢ überwindenden Amplitude eine maximale Impulsbreite nicht über- und/oder eine minimale Impulsbreite nicht unterschreiten und/oder deren Flankensteilheit bestimmten Minimal- und/oder Maximalsteigungen entspricht. Alle diese Ausführungsformen werden hier unter dem Begriff "Schwellwertdetektor" zusammengefasst.

Es versteht sich, dass in zeitdiskreten Realisierungen der Vorrichtung 1 bzw. des von ihr ausgeführten Verfahrens, in welchen alle elektrischen Signale als Folgen von Abtastwerten (samples) vorliegen, bei hohen Abtastraten Gleichzeitigkeit bzw. Koinzidenz nicht nur dann detektiert wird, wenn sich Impulse Eᵤ und Eᵥ in allen ihren Abtastwerten zeitlich decken, sondern bereits eine zeitliche Koinzidenz innerhalb akzeptabler Toleranzen vorliegt, z.B. eine zeitliche Überlappung in nur einigen ihrer Abtastwerte. Fig. 8b zeigt dies anhand von zwei gemäß Fig. 8a schwellwertdetektierten und mittels Analog/DigitalWandler 12, 13 in jeweils 7 Abtastwerten (samples) zeitdiskret abgetasteten und digitalisierten Impulsen Eᵤ und Eᵥ, welche sich - selbst unter Berücksichtigung der Laufzeitunterschiede Δt - nur hinsichtlich zweier Abtastwerte zeitlich überlappen, was jedoch beispielsweise genügen kann, um sie innerhalb vorgegebener Toleranzgrenzen als koinzident zu betrachten, d.h. wenn die Zeitabweichung |ε| kleiner als eine Toleranzgrenze σ ist oder die Zeitabweichung ε zwischen einer unteren Toleranzgrenze σ₋ und eine obere Toleranzgrenze σ₊ liegt.

In der Vorrichtung 1 der Fig. 1 bis 8 läuft somit zusammengefasst folgendes Verfahren ab:
Zunächst wird in einem ersten Schritt das optische Signal x(t) auf zwei oder mehr Empfangselemente 3, 4 aufgeteilt, um elektrische Signale u(t), v(t) zu erzeugen.

Anschließend werden die Tatsache - und optional auch der Auftrittszeitpunkt t_{I} - eines optischen Impulses I detektiert, wenn in zumindest zwei der Signalen u(t), v(t) usw. (laufzeitbereinigt) gleichzeitig ein elektrischer Impuls Eᵤ, Eᵥ usw. auftritt.

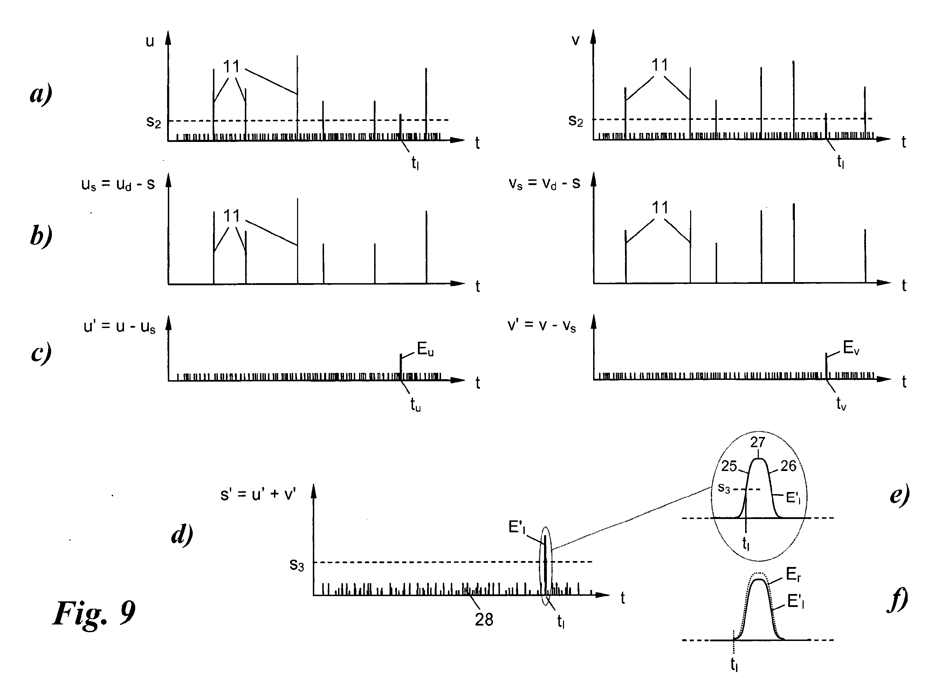

Die Fig. 9 und 10 zeigen Anwendungen der Vorrichtung 1 bzw. des von ihr ausgeübten Verfahrens, bei welchen das Detektionsergebnis s(t) als Zwischenergebnis für eine weitergehende, genauere Bestimmung des Auftrittszeitpunkts t_{I} des optischen Impulses I herangezogen wird. Diese Ausführungsformen beruhen auf einer Analyse der Signale u(t) und v(t) über ihren gesamten Zeitverlauf oder zumindest eines Abschnitts davon und erfordern dazu eine entsprechende zeitliche Aufzeichnung derselben. Die Ausführungsformen der Fig. 9 und 10 sind daher nicht mehr in reiner Analogtechnik oder Echtzeit-Digitalverarbeitung realisierbar, sondern nur mit Hilfe digitalisierter, gespeicherter Signale u(t) und v(t) in der Art einer "Offline"-Auswertung derselben.

Im Weiteren wird auf die Hinzufügung des Zeitindex t bei der Beschreibung aller Signale u(t), v(t), s(t) usw. zur leichteren Beschreibung des Verfahrens verzichtet.

Das Detektionsergebnis s und der darin detektierte, den optischen Impuls I repräsentierende elektrischen Impuls E_{I} werden in der Ausführungsform von Fig. 9 dazu verwendet, die Eingangssignale u und v jeweils um die Störimpulse 11 zu bereinigen. Die Störimpulse 11 können als Störsignale uₛ bzw. vₛ erhalten werden, indem aus den einen Schwellwert s₂ (Fig. 9a) überschreitenden Signalen u_{d}, v_{d}, beispielsweise erhältlich an den Ausgängen 18, 19 der Schwellwertdetektoren 17 (Fig. 4), die detektierten Impulse E_{I} entfernt werden, d.h. uₛ = u_{d} - s und vₛ = v_{d} - s (Fig. 9b).

Die Störsignale uₛ, v_{d} werden anschließend von den Empfangssignalen u, v (Fig. 9a) abgezogen, was bereinigte Empfangssignale u' = u - uₛ, v' = v - vₛ ergibt (Fig. 9c).

Die derart um die Störimpulse 11 bereinigten Empfangssignale u', v' können anschließend für verschiedenste Signalauswertungsverfahren zur genaueren Bestimmung des elektrischen Impulses E_{I} und damit des optischen Impulses I herangezogen werden, beispielsweise durch neuerliche Schwellwertdetektion. Die bereinigten Signale u', v' können jedoch auch lediglich als ein "Satz" {u', v'}von Signalen zusammengestellt werden, welcher *gemeinsam* ausgewertet wird, z.B. durch Vergleich mit einem *Satz* von Referenzimpulsen, wie sie später noch ausführlicher erläutert werden.

Alternativ werden die bereinigten Empfangssignale u', v',... aufsummiert (gemittelt), um ein bereinigtes Summensignal s' = u' + v' + ... zu erzeugen, siehe Fig. 9d. In dem bereinigten Summensignal s' kann der gesuchte elektrische Impuls E_{I} noch besser durch Schwellwertdetektion gegenüber einem Schwellwert s₃ detektiert werden. Ein derartiges Aufsummieren bzw. Mitteln von Eingangssignalen vor einer Schwellwertdetektion ("pre-detection averaging") erhöht in vorteilhafter Weise das Signal/RauschVerhältnis des der Schwellwertdetektion zugeführten Signals s' um die Wurzel aus der Anzahl an aufsummierten Signalen.

Darüber hinaus kann sowohl in den einzelnen bereinigten Empfangssignalen u', v', ... als auch in dem bereinigten Summensignal s' die Zeitlage t_{I} des Impulses E_{I} bzw. des Summenimpulses E'_{I} noch genauer bestimmt werden. Fig. 9e zeigt einen vergrößerten Ausschnitt der Zeitachse t von Fig. 9d, woraus ersichtlich ist, dass der Impuls E'_{I} in der Praxis keine ideale Dirac- oder Rechteckform hat, sondern aufgrund der Bandbegrenzung realer Systeme verschliffene Flanken 25, 26 und einen Scheitel 27. Die Entscheidung, welche genaue Zeitlage (Auftrittszeitpunkt) t_{I} ein solcher realer Impuls E'_{I} hat, kann dann mit Hilfe verschiedenster Verfahren getroffen werden.

Eine erste Variante ist die Detektion des Zeitpunkts t_{I}, wenn eine der Flanken 25 oder 26 einen bestimmten Schwellwert s₃ über- oder unterschreitet (Fig. 9e) oder wenn der Scheitel 27 detektiert wird.

Eine zweite Variante ist in Fig. 9f gezeigt. Hier wird die Signalform des detektierten Impulses E'_{I} mit der Signalform eines bekannten Referenzimpulses Eᵣ, wie sie beispielsweise aus Referenzlaufzeitmessungen erhalten wird, verglichen, d.h. der Impuls E'_{I} wird in den Referenzimpuls Eᵣ optimal "eingepasst" (oder umgekehrt). Ein Referenzzeitpunkt des Referenzimpulses Eᵣ kann dann als Auftrittszeitpunkt t_{I} des Impulses E'_{I} herangezogen werden.

Fig. 10 zeigt eine Abwandlung des Verfahrens von Fig. 9, welche ohne den Schritt des Subtrahierens der Störsignale uₛ, vₛ auskommt, indem aus den Signalen u, v einfach nur jene zeitlichen Abschnitte u", v" entnommen werden, welche ein Zeitfenster knapp um die Auftrittszeitpunkte tᵤ, tᵥ der als koinzident detektierten Empfangsimpulse Eᵤ, Eᵥ definieren (Fig. 10a). Fig. 10b zeigt die entnommenen zeitlichen Abschnitte u", v" vergrößert im Detail: Bereits in diesen Abschnitten u", v" können die Auftrittspunkte tᵤ, tᵥ der Empfangsimpulse Eᵤ, Eᵥ genauer bestimmt werden, z.B. anhand des Schwellwertdetektionsverfahrens von Fig. 9e oder des Referenzimpuls-Einpassungsverfahrens gemäß Fig. 9f. Auch hier können die Abschnitte u", v" wieder als ein Signalsatz {u", v"} gemeinsam ausgewertet werden, z.B. durch Vergleich mit einem Satz von Referenzimpulsen {Eᵣ}.

Bevorzugt werden die entnommenen Abschnitte u" und v" jedoch zu einem Summenabschnitt s" summiert (Fig. 10c), welcher aufgrund der Aufsummierung wieder ein vorteilhaft verbessertes Signal/Rausch-Verhältnis besitzt und damit einer verbesserten Schwellwertdetektion gegenüber dem Schwellwert s₃ oder einer verbesserten Referenzimpuls-Einpassung gemäß Fig. 9f zugeführt werden kann, um den Auftrittszeitpunkt t_{I} noch genauer zu bestimmen.

Die Vorrichtung 1 und die geschilderten Verfahren können auch mit herkömmlichen Pre- und Post-Processing-Vorrichtungen und Verfahren kombiniert werden. Beispielsweise können in oder vor den Empfangskanälen U, V auch herkömmliche Signalverarbeitungsverfahren zur räumlichen, spektralen und/oder zeitlichen Filterung der Signale x, x₁, x₂, u, v und s zum Einsatz kommen.

Die Erfindung umfasst somit eine Vorrichtung mit einem oder mehreren der folgenden Merkmale M1 bis M14 bzw. ein Verfahren mit einem oder mehreren der folgenden Merkmale M15 bis M28:
M1) eine Vorrichtung (1) zur Detektion eines optischen Impulses (I) in einem optischen Signal (x), mit
   zumindest zwei parallelen Empfangskanälen (U, V), denen jeweils ein Anteil (x₁, x₂) des optischen Signals (x) zugeführt ist und die jeweils ein optoelektronisches Empfangselement (3, 4) zur Umwandlung des Anteils (x₁, x₂) in ein elektrisches Signal (u, v) enthalten, in dem sich ein optischer Impuls (I) als elektrischer Impuls (Eᵤ, Eᵥ) niederschlägt, und
   einer an die Empfangselemente (3, 4) angeschlossenen Auswerteschaltung (8), die dafür ausgebildet ist, einen optischen Impuls (I) zu detektieren, wenn in zumindest zwei elektrischen Signalen (u, v) - kompensiert um allfällige Signallaufzeitunterschiede (Δt) zwischen den Empfangskanälen (U, V) - innerhalb vorgegebener Toleranzgrenzen (σ) gleichzeitig ein elektrischer Impuls (Eᵤ, Eᵥ) auftritt;
M2) dass die Auswerteschaltung (8) ferner dafür ausgebildet ist, beim Detektieren den Auftrittszeitpunkt (t_{I}) des optischen Impulses (I) aus dem Auftrittszeitpunkt (tᵤ, tᵥ) zumindest eines der genannten elektrischen Impulse (Eᵤ, Eᵥ) in seinem Signal (u, v) zu bestimmen;
M3) dass zumindest ein Empfangselement (3, 4) eine Lawinenphotodiode oder einen Photoelektronenvervielfacher enthält, bevorzugt einen Hybrid-Photon-Detektor;
M4) dass zumindest ein Empfangselement (3, 4) hochempfindlich und zumindest ein anderes Empfangselement (3, 4) geringempfindlich ist;
M5) dass die Empfangselemente (3, 4) so nahe nebeneinander oder hintereinander versetzt angeordnet sind, dass das optische Signal (x) alle Empfangselemente (3, 4) mit jeweils einem seiner Anteile (x₁, x₂) trifft;
M6) dass ein optischer Strahlteiler (2) zur Aufteilung des optischen Signals (x) in die genannten Anteile (x₁, x₂) vorgesehen ist, welcher den Empfangskanälen (U, V) vorgeschaltet ist;
M7) dass die Anteile (x₁, x₂) ungleich groß sind;
M8) dass dem Empfangskanal (U, V) mit dem hochempfindlichen Empfangselement (3, 4) der größere Anteil (x₁, x₂) zugeführt ist;
M9) dass die Auswerteschaltung (8) einen an die Ausgänge (6, 7) aller Empfangselemente (3, 4) angeschlossenen Multiplizierer (14) aufweist, dessen Ausgang einem Schwellwertdetektor (15) zugeführt ist;
M10) dass die Auswerteschaltung (8) für jedes Empfangselement (3, 4) einen an dessen Ausgang (6, 7) angeschlossenen Schwellwertdetektor (17) aufweist, wobei die Ausgänge (18, 19) aller Schwellwertdetektoren (17) einem UND-Glied (20) zugeführt sind;
M11) dass die Auswerteschaltung (8) dafür ausgebildet ist, einen optischen Impuls (I) nur dann zu detektieren, wenn die in einem vorgegebenen Zeitabstand (Δt) auftretenden elektrischen Impulse (Eᵤ, Eᵥ) - gegebenenfalls kompensiert um Verstärkungsunterschiede der Empfangselemente (3, 4) und um das Verhältnis (x₁:x₂) der Strahlteilung - auch annähernd gleiche Amplitude haben;
M12) dass die Auswerteschaltung (8) dafür ausgebildet ist, einen optischen Impuls (I) nur dann zu detektieren, wenn die in einem vorgegebenen Zeitabstand (Δt) auftretenden elektrischen Impulse (Eᵤ, Eᵥ) auch annähernd gleiche oder einander in einer Datenbank (24) zugeordnete (P₁, P₂) Impulsformen (Fᵤ, Fᵥ) oder Impulsform-Parameter (Bᵤ, Bᵥ; Sᵤ, Sᵥ) haben;
M13) dass sie in Analogtechnik aufgebaut ist;
M14) dass die Ausgänge (6, 7) der Empfangselemente (3, 4) über Analog/Digital-Wandler (12, 13) geführt sind und die übrige Vorrichtung (1) in Digitaltechnik aufgebaut ist;
M15) ein Verfahren zur Detektion eines optischen Impulses (I) in einem optischen Signal (x), umfassend:
   Aufteilen des optischen Signals (x) auf zumindest zwei parallele Empfangskanäle (U, V) mit jeweils einem opto-elektronischen Empfangselement (3, 4), welches den jeweiligen Anteil (x₁, x₂) des optischen Signals (x) in ein elektrisches Signal (u, v) umwandelt, in dem sich ein optischer Impuls (I) als elektrischer Impuls (Eᵤ, Eᵥ) niederschlägt; und
   Detektieren eines optischen Impulses (I), wenn in zumindest zwei elektrischen Signalen (u, v) - kompensiert um allfällige Signallaufzeitunterschiede (Δt) zwischen den Empfangskanälen (U, V) - innerhalb vorgegebener Toleranzgrenzen (σ) gleichzeitig ein elektrischer Impuls (Eᵤ, Eᵥ) auftritt;
M16) dass beim Detektieren der Auftrittszeitpunkt (t_{I}) des optischen Impulses (I) aus dem Auftrittszeitpunkt (tᵤ, tᵥ) zumindest eines der genannten elektrischen Impulse (Eᵤ, Eᵥ) in seinem Signal (u, v) bestimmt wird;
M17) dass der Auftrittszeitpunkt (tᵤ, tᵥ, t_{I}) durch Vergleichen eines elektrischen Impulses (Eᵤ, Eᵥ, E_{I}) mit einem Referenzimpuls (Eᵣ) bekannter Zeitlage bestimmt wird;
M18) dass das optische Signal (x) in zwei ungleich große Anteile (x₁, x₂) aufgeteilt wird;
M19) dass der größere Anteil (x₁, x₂) einem Empfangskanal (U, V) mit einem hochempfindlichen Empfangselement (3, 4) und der kleinere Anteil (x₁, x₂) einem Empfangskanal (U, V) mit einem geringempfindlichen Empfangselement (3, 4) zugeführt wird;
M20) dass zum Detektieren die Signale (u, v) miteinander multipliziert (14) werden und das Multiplikationsergebnis einem Schwellwertdetektor (15) zugeführt wird;
M21) dass zum Detektieren die Signale (u, v) jeweils über einen Schwellwertdetektor (17) geführt und anschließend UNDverknüpft (20) werden;
M22) dass ein optischer Impuls (I) nur dann detektiert wird, wenn die in einem vorgegebenen Zeitabstand (Δt) auftretenden elektrischen Impulse (Eᵤ, Eᵥ) - gegebenenfalls kompensiert um Verstärkungsunterschiede der Empfangselemente (3, 4) und um das Verhältnis (x₁:x₂) der Strahlteilung - auch annähernd gleiche Amplitude haben;
M23) dass ein optischer Impuls (I) nur dann detektiert wird, wenn die in einem vorgegebenen Zeitabstand (Δt) auftretenden elektrischen Impulse (Eᵤ, Eᵥ) auch annähernd gleiche oder einander in einer Datenbank (24) zugeordnete (P₁, P₂) Impulsformen (Fᵤ, Fᵥ) oder Impulsform-Parameter (Bᵤ, Bᵥ; Sᵤ, Sᵥ) haben;
M24) mit den weiteren Schritten:
   Entfernen aller einen Schwellwert (s₂) überschreitenden elektrischen Impulse (11) mit Ausnahme des zum Zeitpunkt des detektierten optischen Impulses (I) auftretenden elektrischen Impulses (Eᵤ, Eᵥ, E_{I}) aus zumindest einem der Signale (u, v), um zumindest ein auf diese Weise bereinigtes Signal (u', v') zu erzeugen; und
   Verwenden des zumindest einen bereinigten Signals (u', v') zur genaueren Bestimmung des Auftrittszeitpunkts (t_{I});
M25) mit den weiteren Schritten:
   Entnehmen eines Abschnitts (u", v") aus zumindest einem der Signale (u, v), welcher durch ein Zeitfenster um den Auftrittszeitpunkt (tᵤ, tᵥ, t_{I}) des genannten elektrischen Impulses (Eᵤ, Eᵥ, E_{I}) darin definiert ist; und
   Verwenden des zumindest einen entnommenen Abschnitts (u", v") zur genaueren Bestimmung des Auftrittszeitpunkts (t_{I});
M26) dass bereinigte Signale (u', v') bzw. Abschnitte (u", v") aus zumindest zwei Signalen (u, v) auf diese Weise erzeugt und zu einem Signalsatz ({u', v'}) zusammengestellt oder zu einem Summensignal (s', s") summiert werden, welcher bzw. welches zur genaueren Bestimmung des Auftrittszeitpunkts (t_{I}) verwendet wird;
M27) dass der Auftrittszeitpunkt (t_{I}) durch Schwellwertdetektion im Summensignal (s', s") bestimmt wird;
M28) dass der Auftrittszeitpunkt (t_{I}) durch Vergleichen eines im Summensignal (s', s") auftretenden elektrischen Impulses (E'_{I}) mit einem Referenzimpuls (Eᵣ) bekannter Zeitlage bestimmt wird.

Die Erfindung ist demgemäß nicht auf die dargestellten Ausführungsformen beschränkt, sondern umfasst alle Varianten und Modifikationen, die in den Rahmen der angeschlossenen Ansprüche fallen. So kann alles, was bislang über lediglich zwei Empfangskanäle bzw. -elemente und deren zwei Signale gesagt wurde, auf beliebig viele Empfangskanäle bzw. -elemente und Signale erweitert werden.

## Patentansprüche

1. Vorrichtung (1) zur Laufzeitmessung eines optischen Impulses (I), der von der Vorrichtung (1) zu einem bekannten Sendezeitpunkt ausgesandt, an einem Umgebungsobjekt reflektiert und in der Vorrichtung (1) in einem optischen Signal (x) zu einem Auftrittszeitpunkt (t_{I}) empfangen wird, mit
zumindest zwei parallelen Empfangskanälen (U, V), denen jeweils ein Anteil (x₁, x₂) des optischen Signals (x) zugeführt ist und die jeweils ein optoelektronisches Empfangselement (3, 4) zur Umwandlung des Anteils (x₁, x₂) in ein elektrisches Signal (u, v) enthalten, in dem sich ein optischer Impuls (I) als elektrischer Impuls (Eᵤ, Eᵥ) niederschlägt, **gekennzeichnet durch**
eine an die Empfangselemente (3, 4) angeschlossene Auswerteschaltung (8), die dafür ausgebildet ist, einen optischen Impuls (I) und seinen Auftrittszeitpunkt (t_{I}) nur dann zu detektieren, wenn in zumindest zwei elektrischen Signalen (u, v) - kompensiert um allfällige Signallaufzeitunterschiede (Δt) zwischen den Empfangskanälen (U, V) - innerhalb vorgegebener Toleranzgrenzen (σ) gleichzeitig ein elektrischer Impuls (Eᵤ, Eᵥ) auftritt, und aus der Differenz zwischen bekanntem Sendezeitpunkt und detektiertem Auftrittszeitpunkt (t_{I}) die Impulslaufzeit zu bestimmen.

2. Vorrichtung nach Anspruch 1, **dadurch gekennzeichnet, dass** zumindest ein Empfangselement (3, 4) eine Lawinenphotodiode oder einen Photoelektronenvervielfacher enthält, bevorzugt einen Hybrid-Photon-Detektor.

3. Vorrichtung Anspruch 1 oder 2, **dadurch gekennzeichnet, dass** zumindest ein Empfangselement (3, 4) hochempfindlich und zumindest ein anderes Empfangselement (3, 4) geringempfindlich ist, dass die Anteile (x₁, x₂) ungleich groß sind, und dass dem Empfangskanal (U, V) mit dem hochempfindlichen Empfangselement (3, 4) der größere Anteil (x₁, x₂) zugeführt ist.

4. Vorrichtung nach einem der Ansprüche 1 bis 3, **dadurch gekennzeichnet, dass** die Auswerteschaltung (8) einen an die Ausgänge (6, 7) aller Empfangselemente (3, 4) angeschlossenen Multiplizierer (14) aufweist, dessen Ausgang einem Schwellwertdetektor (15) zugeführt ist.

5. Vorrichtung nach einem der Ansprüche 1 bis 4, **dadurch gekennzeichnet, dass** die Auswerteschaltung (8) für jedes Empfangselement (3, 4) einen an dessen Ausgang (6, 7) angeschlossenen Schwellwertdetektor (17) aufweist, wobei die Ausgänge (18, 19) aller Schwellwertdetektoren (17) einem UND-Glied (20) zugeführt sind.

6. Vorrichtung nach einem der Ansprüche 1 bis 5, **dadurch gekennzeichnet, dass** die Auswerteschaltung (8) dafür ausgebildet ist, einen optischen Impuls (I) nur dann zu detektieren, wenn die in einem vorgegebenen Zeitabstand (Δt) auftretenden elektrischen Impulse (Eᵤ, Eᵥ) - gegebenenfalls kompensiert um Verstärkungsunterschiede der Empfangselemente (3, 4) und um das Verhältnis (x₁:x₂) der Strahlteilung - auch annähernd gleiche Amplitude haben.

7. Vorrichtung nach einem der Ansprüche 1 bis 6, **dadurch gekennzeichnet, dass** die Auswerteschaltung (8) dafür ausgebildet ist, einen optischen Impuls (I) nur dann zu detektieren, wenn die in einem vorgegebenen Zeitabstand (Δt) auftretenden elektrischen Impulse (Eᵤ, Eᵥ) auch annähernd gleiche oder einander in einer Datenbank (24) zugeordnete (P₁, P₂) Impulsformen (Fᵤ, Fᵥ) oder Impulsform-Parameter (Bᵤ, Bᵥ; Sᵤ, Sᵥ) haben.

8. Verfahren zur Laufzeitmessung eines optischen Impulses (I), der zu einem bekannten Sendezeitpunkt ausgesandt, an einem Umgebungsobjekt reflektiert und in einem optischen Signal (x) zu einem Auftrittszeitpunkt (t_{I}) empfangen wird, umfassend:
Aufteilen des optischen Signals (x) auf zumindest zwei parallele Empfangskanäle (U, V) mit jeweils einem opto-elektronischen Empfangselement (3, 4), welches den jeweiligen Anteil (x₁, x₂) des optischen Signals (x) in ein elektrisches Signal (u, v) umwandelt, in dem sich ein optischer Impuls (I) als elektrischer Impuls (Eᵤ, Eᵥ) niederschlägt; **gekennzeichnet durch**:
Detektieren eines optischen Impulses (I) und seines Auftrittszeitpunkts (t_{I}) nur dann, wenn in zumindest zwei elektrischen Signalen (u, v) - kompensiert um allfällige Signallaufzeitunterschiede (Δt) zwischen den Empfangskanälen (U, V) - innerhalb vorgegebener Toleranzgrenzen (σ) gleichzeitig ein elektrischer Impuls (Eᵤ, Eᵥ) auftritt; und
Bestimmen der Impulslaufzeit aus der Differenz zwischen bekanntem Sendezeitpunkt und detektiertem Auftrittszeitpunkt (t_{I}).

9. Verfahren nach Anspruch 8, **dadurch gekennzeichnet, dass** beim Detektieren der Auftrittszeitpunkt (t_{I}) des optischen Impulses (I) aus dem Auftrittszeitpunkt (tᵤ, tᵥ) zumindest eines der genannten elektrischen Impulse (Eᵤ, Eᵥ) in seinem Signal (u, v) bestimmt wird.

10. Verfahren nach Anspruch 9, **dadurch gekennzeichnet, dass** der Auftrittszeitpunkt (tᵤ, tᵥ, t_{I}) durch Vergleichen eines elektrischen Impulses (Eᵤ, Eᵥ, E_{I}) mit einem Referenzimpuls (Er) bekannter Zeitlage bestimmt wird.

11. Verfahren nach einem der Ansprüche 8 bis 10, **dadurch gekennzeichnet, dass** das optische Signal (x) in zwei ungleich große Anteile (x₁, x₂) aufgeteilt wird, und dass der größere Anteil (x₁, x₂) einem Empfangskanal (U, V) mit einem hochempfindlichen Empfangselement (3, 4) und der kleinere Anteil (x₁, x₂) einem Empfangskanal (U, V) mit einem geringempfindlichen Empfangselement (3, 4) zugeführt wird.

12. Verfahren nach einem der Ansprüche 8 bis 11, **dadurch gekennzeichnet, dass** ein optischer Impuls (I) nur dann detektiert wird, wenn die in einem vorgegebenen Zeitabstand (Δt) auftretenden elektrischen Impulse (Eᵤ, Eᵥ) - gegebenenfalls kompensiert um Verstärkungsunterschiede der Empfangselemente (3, 4) und um das Verhältnis (x₁:x₂) der Strahlteilung - auch annähernd gleiche Amplitude haben.

13. Verfahren nach einem der Ansprüche 8 bis 12, **dadurch gekennzeichnet, dass** ein optischer Impuls (I) nur dann detektiert wird, wenn die in einem vorgegebenen Zeitabstand (Δt) auftretenden elektrischen Impulse (Eᵤ, Eᵥ) auch annähernd gleiche oder einander in einer Datenbank (24) zugeordnete (P₁, P₂) Impulsformen (Fᵤ, Fᵥ) oder Impulsform-Parameter (Bᵤ, Bᵥ; Sᵤ, Sᵥ) haben.

14. Verfahren nach einem der Ansprüche 8 bis 13, umfassend
Entfernen aller einen Schwellwert (s₂) überschreitenden elektrischen Impulse (11) mit Ausnahme des zum Zeitpunkt des detektierten optischen Impulses (I) auftretenden elektrischen Impulses (Eᵤ, Eᵥ, E_{I}) aus zumindest einem der Signale (u, v), um zumindest ein auf diese Weise bereinigtes Signal (u', v') zu erzeugen, und Verwenden des zumindest einen bereinigten Signals (u', v') zur genaueren Bestimmung des Auftrittszeitpunkts (t_{I}); oder
Entnehmen eines Abschnitts (u", v") aus zumindest einem der Signale (u, v), welcher durch ein Zeitfenster um den Auftrittszeitpunkt (tᵤ, tᵥ, t_{I}) des genannten elektrischen Impulses (Eᵤ, Eᵥ, E_{I}) darin definiert ist, und Verwenden des zumindest einen entnommenen Abschnitts (u", v") zur genaueren Bestimmung des Auftrittszeitpunkts (t_{I}).

15. Verfahren nach Anspruch 14, **dadurch gekennzeichnet, dass** bereinigte Signale (u', v') bzw. Abschnitte (u", v") aus zumindest zwei Signalen (u, v) auf diese Weise erzeugt und zu einem Signalsatz ({u', v'}) zusammengestellt oder zu einem Summensignal (s', s") summiert werden, welcher bzw. welches zur genaueren Bestimmung des Auftrittszeitpunkts (t_{I}) verwendet wird.

## Claims

1. A device (1) for measuring the time of flight of an optical pulse (I) which is transmitted from the device (1) at a known moment of transmission, is reflected on an ambient object and is received in the device (1) in an optical signal (x) at a moment of appearance (t_{I}), comprising
at least two parallel receiving channels (U, V), to each of which a portion (x₁, x₂) of the optical signal (x) is fed and which each contain an optoelectronic receiving element (3, 4) for converting the portion (x₁, x₂) into an electric signal (u, v), in which an optical pulse (I) is reflected as an electric pulse (Eᵤ, Eᵥ), **characterised by**
an evaluation circuit (8), which is connected to the receiving elements (3, 4) and which is designed to only then detect an optical pulse (I) and the moment of appearance (t_{I}) thereof when an electric pulse (Eᵤ, Eᵥ) occurs simultaneously in at least two electric signals (u, v) - compensated by possible signal time of flight differences (Δt) between the receiving channels (U, V) - within predefined tolerance limits (σ), and to determine the pulse time of flight from the difference between the known moment of transmission and the detected moment of appearance (t_{I}).

2. The device according to Claim 1, **characterised in that** at least one receiving element (3, 4) contains an avalanche photodiode or a photomultiplier, preferably a hybrid photon detector.

3. The device according to Claim 1 or 2, **characterised in that** at least one receiving element (3, 4) is highly sensitive and at least one other receiving element (3, 4) is slightly sensitive, **in that** the portions (x₁, x₂) are of different size, and **in that** the larger portion (x₁, x₂) is fed to the receiving channel (U, V) having the highly sensitive receiving element (3, 4).

4. The device according to one of Claims 1 to 3, **characterised in that** the evaluation circuit (8) comprises a multiplier (14) which is connected to the outputs (6, 7) of all receiving elements (3, 4) and of which the output is fed to a threshold detector (15).

5. The device according to one of Claims 1 to 4, **characterised in that** the evaluation circuit (8) comprises, for each receiving element (3, 4), a threshold detector (17) connected to the output (6, 7) thereof, wherein the outputs (18, 19) of all threshold detectors (17) are fed to an AND member (20).

6. The device according to one of Claims 1 to 5, **characterised in that** the evaluation circuit (8) is designed to then only detect an optical pulse (I) when the electric pulses (Eᵤ, Eᵥ) occurring at a predefined interval (Δt) - where applicable compensated by amplification differences of the receiving elements (3, 4) and by the ratio (x₁:x₂) of the beam division - also have approximately identical amplitudes.

7. The device according to one of Claims 1 to 6, **characterised in that** the evaluation circuit (8) is designed to then only detect an optical pulse (I) if the electric pulses (Eᵤ, Eᵥ) occurring at a predefined interval (Δt) also have approximately identical pulse shapes (Fᵤ, Fᵥ) or pulse shape parameters (Bᵤ, Bᵥ; Sᵤ, Sᵥ) or have pulse shapes or pulse shape parameters that are associated (P₁, P₂) with one another in a database (24).

8. A method for measuring the time of flight of an optical pulse (I) which is transmitted at a known moment of transmission, is reflected on an ambient object and is received in an optical signal (x) at a moment of appearance (t_{I}), comprising:
dividing the optical signal (x) between at least two parallel receiving channels (U, V), each having an optoelectronic receiving element (3, 4) which converts the respective portion (x₁, x₂) of the optical signal (x) into an electric signal (u, v), in which an optical pulse (I) is reflected as an electric pulse (Eᵤ, Eᵥ), **characterised by**:
then only detecting an optical pulse (I) and the moment of appearance (t_{I}) thereof when an electric pulse (Eᵤ, Eᵥ) occurs simultaneously in at least two electric signals (u, v) - compensated by possible signal time of flight differences (Δt) between the receiving channels (U, V) - within predefined tolerance limits (σ); and
determining the pulse time of flight from the difference between the known moment of transmission and the detected moment of appearance (t_{I}).

9. The method according to Claim 8, **characterised in that**, when detecting, the moment of appearance (t_{I}) of the optical pulse (I) is determined from the moment of appearance (tᵤ, tᵥ) of at least one of the aforementioned electric pulses (Eᵤ, Eᵥ) in the signal thereof (u, v).

10. The method according to Claim 9, **characterised in that** the moment of appearance (tᵤ, tᵥ, t_{I}) is determined by comparing an electric pulse (Eᵤ, Eᵥ, E_{I}) with a reference pulse (Eᵣ) of known position in time.

11. The method according to one of Claims 8 to 10, **characterised in that** the optical signal (x) is divided into two portions (x₁, x₂) of different size, and **in that** the larger portion (x₁, x₂) is fed to a receiving channel (U, V) having a highly sensitive receiving element (3, 4) and the smaller portion (x₁, x₂) is fed to a receiving channel (U, V) having a slightly sensitive receiving element (3, 4).

12. The method according to one of Claims 8 to 11, **characterised in that** an optical pulse (I) is then only detected if the electric pulses (Eᵤ, Eᵥ) occurring at a predefined interval (Δt) - where applicable compensated by amplification differences of the receiving elements (3, 4) and by the ratio (x₁:x₂) of the beam division - also have approximately identical amplitudes.

13. The method according to one of Claims 8 to 12, **characterised in that** an optical pulse (I) is only then detected if the electric pulses (Eᵤ, Eᵥ) occurring at a predefined interval (Δt) also have approximately identical pulse shapes (Fᵤ, Fᵥ) or pulse shape parameters (Bᵤ, Bᵥ; Sᵤ, Sᵥ) or have pulse shapes or pulse shape parameters that are associated (P₁, P₂) with one another in a database (24).

14. The method according to one of Claims 8 to 13, comprising
removing all electric pulses (11) exceeding a threshold value (s₂) with the exception of the electric pulse (Eᵤ, Eᵥ, E_{I}), occurring at the moment of the detected optical pulse (I), from at least one of the signals (u, v), in order to generate at least one signal (u', v') rectified in this way, and using the at least one rectified signal (u', v') to more accurately determine the moment of appearance (t_{I}); or
removing a portion (u", v") from at least one of the signals (u, v), said portion being defined by a time window around the moment of appearance (tᵤ, tᵥ, t_{I}) of the aforementioned electric pulse (Eᵤ, Eᵥ, E_{I}) therein, and using the at least one removed portion (u", v") to more accurately determine the moment of occurrence (t_{I}).

15. The method according to Claim 14, **characterised in that** rectified signals (u', v') or portions (u", v") are generated in this way from at least two signals (u, v) and are compiled to form a single signal set ({u', v'}) or are summed to form a sum signal (s', s"), which is used to more accurately determine the moment of appearance (t_{I}).

## Revendications

1. Dispositif (1) pour la mesure du temps de vol d'une impulsion optique (I) émise par le dispositif (1) à un instant d'émission connu, réfléchie sur un objet environnant et reçue dans le dispositif (1) dans un signal optique (x) à un instant d'apparition (t_{I}), avec
au moins deux canaux de réception parallèles (U, V) recevant respectivement une partie (x₁, x₂) du signal optique (x) et contenant respectivement un élément de réception optoélectronique (3, 4) pour la conversion de la partie (x₁, x₂) en un signal électrique (u, v), dans lequel une impulsion optique (I) se manifeste en tant qu'impulsion électrique (Eu, Eᵥ), **caractérisé par**
un circuit d'évaluation (8) raccordé aux éléments de réception (3, 4) et conçu pour détecter une impulsion optique (I) et son instant d'apparition (t_{I}) seulement lorsqu'une impulsion électrique (Eᵤ, Eᵥ) apparaît simultanément dans des limites de tolérance prédéfinies (σ) dans au moins deux signaux électriques (u, v) - avec compensation des éventuels écarts de temps de vol du signal (Δt) entre les canaux de réception (U, V) - et pour déterminer le temps de vol de l'impulsion à partir de l'écart entre l'instant d'émission connu et l'instant d'apparition (t_{I}) détecté.

2. Dispositif selon la revendication 1, **caractérisé en ce qu'**au moins un élément de réception (3, 4) contient une photodiode à avalanche ou un multiplicateur de photoélectrons, de préférence un détecteur de photons hybride.

3. Dispositif selon la revendication 1 ou 2, **caractérisé en ce qu'**au moins un élément de réception (3, 4) est très sensible et au moins un autre élément de réception (3, 4) est peu sensible, **en ce que** les parties (x₁, x₂) sont de tailles différentes et **en ce que** le canal de réception (U, V) avec l'élément de réception (3, 4) très sensible reçoit la partie (x₁, x₂) la plus grande.

4. Dispositif selon l'une des revendications 1 à 3, **caractérisé en ce que** le circuit d'évaluation (8) comporte un multiplicateur (14) raccordé aux sorties (6, 7) de tous les éléments de réception (3, 4), et dont la sortie est reliée à un détecteur de valeur seuil (15).

5. Dispositif selon l'une des revendications 1 à 4, **caractérisé en ce que** le circuit d'évaluation (8) comporte un détecteur de valeur seuil (17) pour chaque élément de réception (3, 4), raccordé à la sortie (6, 7) de celui-ci, les sorties (18, 19) de tous les détecteurs de valeur seuil (17) étant reliées à un élément ET (20).

6. Dispositif selon l'une des revendications 1 à 5, **caractérisé en ce que** le circuit d'évaluation (8) est conçu pour détecter une impulsion optique (I) seulement lorsque les impulsions électriques (Eu, Eᵥ) apparaissant dans un intervalle de temps prédéfini (Δt) - avec compensation éventuelle des écarts de gain des éléments de réception (3, 4) et du rapport (x₁:x₂) de répartition du faisceau - présentent une amplitude approximativement égale.

7. Dispositif selon l'une des revendications 1 à 6, **caractérisé en ce que** le circuit d'évaluation (8) est conçu pour détecter une impulsion optique (I) seulement lorsque les impulsions électriques (Eᵤ, Eᵥ) apparaissant dans un intervalle de temps prédéfini (Δt) présentent également des formes d'impulsion (Fᵤ, Fᵥ) ou des paramètres de forme d'impulsion (Bᵤ, Bᵥ ; Sᵤ, Sᵥ) approximativement identiques ou attribués les uns aux autres (P₁, P₂) dans une banque de données (24).

8. Procédé pour la mesure du temps de vol d'une impulsion optique (I) émise à un instant d'émission connu, réfléchie sur un objet environnant et reçue dans un signal optique (x) à un instant d'apparition (t_{I}), comprenant :
la répartition du signal optique (x) sur au moins deux canaux de réception (U, V) parallèles, comportant respectivement un élément de réception optoélectronique (3, 4), lequel convertit la partie (x₁, x₂) respective du signal optique (x) en un signal électrique (u, v) dans lequel une impulsion optique (I) se manifeste en tant qu'impulsion électrique (Eᵤ, Eᵥ) ; **caractérisé par** :
la détection d'une impulsion optique (I) et de son instant d'apparition (t_{I}) seulement lorsqu'une impulsion électrique (Eᵤ, Eᵥ) apparaît simultanément dans des limites de tolérance prédéfinies (σ) dans au moins deux signaux électriques (u, v) - avec compensation des éventuels écarts de temps de vol du signal (Δt) entre les canaux de réception (U, V) ; et
la détermination du temps de vol de l'impulsion à partir de l'écart entre l'instant d'émission connu et l'instant d'apparition (t_{I}) détecté.

9. Procédé selon la revendication 8, **caractérisé en ce que** lors de la détection, l'instant d'apparition (t_{I}) de l'impulsion optique (I) est déterminé à partir de l'instant d'apparition (tᵤ, tᵥ) d'au moins l'une desdites impulsions électriques (Eᵤ, Eᵥ) dans son signal (u, v).

10. Procédé selon la revendication 9, **caractérisé en ce que** l'instant d'apparition (tᵤ, tᵥ, t_{I}) est déterminé par comparaison d'une impulsion électrique (Eᵤ, Eᵥ, E_{I}) avec une impulsion de référence (Eᵣ) présentant une position temporelle connue.

11. Procédé selon l'une des revendications 8 à 10, **caractérisé en ce que** le signal optique (x) est divisé en deux parties (x₁, x₂) de tailles inégales, et **en ce que** la partie (x₁, x₂) la plus grande est transmise à un canal de réception (U, V) avec un élément de réception (3, 4) très sensible, et la partie (x₁, x₂) la plus petite est transmise à un canal de réception (U, V) avec une élément de réception (3, 4) peu sensible.

12. Procédé selon l'une des revendications 8 à 11, **caractérisé en ce qu'**une impulsion optique (I) est détectée seulement lorsque les impulsions électriques (Eᵤ, Eᵥ) apparaissant dans un intervalle de temps prédéfini (Δt)
- avec compensation éventuelle des écarts de gain des éléments de réception (3, 4) et du rapport (x₁:x₂) de répartition du faisceau - présentent également une amplitude approximativement égale.

13. Procédé selon l'une des revendications 8 à 12, **caractérisé en ce qu'**une impulsion optique (I) est détectée seulement lorsque les impulsions électriques (Eᵤ, Eᵥ) apparaissant dans l'intervalle de temps prédéfini (Δt) présentent également des formes d'impulsion (Fᵤ, Fᵥ) ou des paramètres de forme d'impulsion (Bᵤ, Bᵥ; Sᵤ, Sᵥ) approximativement identiques ou attribués les uns aux autres (P₁, P₂) dans une banque de données (24).

14. Procédé selon l'une des revendications 8 à 13, comprenant :
l'élimination de toutes les impulsion électrique (11) dépassant une valeur seuil (s₂), à l'exception de l'impulsion électrique (Eᵤ, Eᵥ, E_{I}) apparaissant à l'instant de l'impulsion optique (I) détectée, à partir d'au moins l'un des signaux (u, v), pour ainsi produire au moins un signal ajusté (u', v'), et utilisation de l'au moins un signal ajusté (u', v') pour une détermination plus précise de l'instant d'apparition (t_{I}) ; ou
extraction d'une section (u", v") à partir d'au moins l'un des signaux (u, v), laquelle est définie par une fenêtre temporelle autour de l'instant d'apparition (tᵤ, tᵥ, t_{I}) de ladite impulsion électrique (Eᵤ, Eᵥ, E_{I}), et utilisation de l'au moins une section extraite (u", v") pour une détermination plus précise de l'instant d'apparition (t_{I}).

15. Procédé selon la revendication 14, **caractérisé en ce que** les signaux ajustés (u', v') ou les sections (u", v") sont produits de cette manière à partir d'au moins deux signaux (u, v) et assemblés en un ensemble de signaux ({u', v'}) ou additionnés en un signal global (s', s") utilisé pour une détermination plus précise de l'instant d'apparition (t_{I}) .
